(19) Europäisches Patentamt
European Patent Office
Office européen des brevets

(11) **EP 1 760 132 B1**

(12) **EUROPEAN PATENT SPECIFICATION**

(45) Date of publication and mention
of the grant of the patent:
**03.12.2008 Bulletin 2008/49**

(51) Int Cl.:
*C09J 7/02* (2006.01)

(21) Application number: **06018448.8**

(22) Date of filing: **04.09.2006**

(54) **Pressure-sensitive adhesive sheet and method of processing articles**

Druckempfindliches Klebeblatt und Verfahren zum Bearbeiten von Gegenständen

Feuille adhésive sensible à la pression et procédé de traitement d'articles

(84) Designated Contracting States:
**DE**

(30) Priority: **06.09.2005 JP 2005257680**

(43) Date of publication of application:
**07.03.2007 Bulletin 2007/10**

(73) Proprietor: **NITTO DENKO CORPORATION**
**Ibaraki**
**Osaka 567-8680 (JP)**

(72) Inventors:
• **Yano, Kohei**
**Ibaraki**
**Osaka 567-8680 (JP)**
• **Akazawa, Kouji**
**Ibaraki**
**Osaka 567-8680 (JP)**
• **Yoshida, Yoshinori**
**Ibaraki**
**Osaka 567-8680 (JP)**
• **Kontani, Tomohiro**
**Ibaraki**
**Osaka 567-8680 (JP)**

(74) Representative: **Albrecht, Thomas et al**
**Kraus & Weisert**
**Patent- und Rechtsanwälte**
**Thomas-Wimmer-Ring 15**
**80539 München (DE)**

(56) References cited:
**EP-A2- 0 999 250**        **JP-A- 2004 107 644**

**Description**

BACKGROUND OF THE INVENTION

Field of the Invention

The present invention relates to a pressure-sensitive adhesive sheet and a method of processing an article using the same. In particular, it relates to a pressure-sensitive adhesive sheet used in a process of high-precision processing of semiconductor products and so on such as semiconductor wafers and optical products in order to hold or protect such products. Also, it relates to a method of processing an article using such a pressure-sensitive adhesive sheet.

Description of a Related Art

In some industrial fields such as optical industries and semiconductor industries, pressure-sensitive adhesive sheets are used in high-precision processing optical parts such as lenses or semiconductor articles such as semiconductor wafers in order to protect the surface of wafers and the like or prevent breakage thereof.

For example, in the process of producing semiconductor chips, the semiconductor chips are produced as follows. First a high-purity silicon single crystal or the like is sliced to form wafers. A predetermined circuit pattern such as IC is formed on the wafer by etching to incorporate an integrated circuit. Then, the back side of the wafer is ground by a grinder to a thickness as thin as about 100 to about 600 $\mu$m. Finally, the wafer is diced into chips. Since the semiconductor wafer in itself is thin and brittle and the circuit pattern is uneven, the wafer tends to be broken if external force is applied to the wafer when it is transported to the steps of grinding and dicing. Consequently, to protect, for example, the circuit pattern surface and prevent breakage of the semiconductorwafer, it has been widely practiced to apply a pressure-sensitive adhesive sheet on the circuit pattern surface of the semiconductor wafer before the operation can be performed.

Examples of known pressure-sensitive adhesive sheet used here include pressure-sensitive adhesive sheets, for example, those including base material sheets made of, for example, polyethylene terephthalate (PET), polyethylene PE), polypropylene (PP), ethylene-vinyl acetate copolymers (EVA), having respective pressure-sensitive adhesive layers thereon.

However, in recent years, differences in height of unevenness of the surface of a circuit pattern on the wafer is increasing and on the otherhand, thinner semiconductorwafers having thicknesses as thin as below 100 $\mu$m are being required for ultra-thin chips such as IC cards, stacked IC. Accordingly, in the case of a conventional pressure-sensitive adhesive sheet having a flexible base material such as one made of EVA, the pressure-sensitive adhesive sheet can follow up such unevenness of the surface of a circuit pattern without problems. However, such a pressure-sensitive adhesive sheet has insufficient rigidity, so that wafers will be curled after their grinding or they will be bent due to their own weight. The curled or bent wafers can neither be transported by a conventional transporting system nor stored in a generally used by storage box for wafers only.

Accordingly, a base may be conceived in which a PET-based base, which has rigidity, and an EVA-based base, which is flexible, are affixed together. However, if these base are mechanically bonded together through an adhesive by using a machine, the stress given upon the lamination remains in the resultant film so that the base will be curled. Further, when a laminate is formed by a T-die method or a calendering method, residual stress tends to occur in the film due to heat-shrinking upon the film formation. When a pressure-sensitive adhesive sheet with such a base in which residual stress has occurred is used in the production of wafers, wafers tend to be broken when the wafers are ground or the wafers after the grinding tend to cause unnegligible curls due to the strain in the pressure-sensitive adhesive sheet as a result of tensile stress, pressure and the like when the films are bonded together.

Various pressure-sensitive adhesive sheets have been proposed which are intended to decrease residual stress. For example, Japanese Patent Application Laid-open (kokai) No. 2000-150432 discloses a pressure-sensitive adhesive sheet having stress relaxation ratio of 40%/minute or more at 10% elongation in a tensile test. Japanese Patent Application Laid-open (kokai) No. 2003-261842 discloses a pressure-sensitive adhesive sheet that includes a base having a rigid film bonded to a stress-relaxed film through an adhesive layer. Japanese Patent Applications Laid-open (kokai) Nos. 2004-200451 and 2005-19518 disclose pressure-sensitive adhesive sheets that include a base containing a unit layer with a specified elastic modulus in tension and having provided thereon a pressure-sensitive adhesive layer. Further, Japanese Patent Application Laid-open (kokai) No. 2002-69396 discloses a pressure-sensitive adhesive film for protecting semiconductor wafers, including outermost layers with a low elastic modulus and an inner layer having a low elastic modulus.

Further, Japanese Patent Applications Laid-open (kokai) Nos. 2004-107644 and 2004-122758 disclose pressure-sensitive adhesive sheets that include a composite film containing a urethane polymer and a vinyl polymer as active ingredients as an intermediate layer.

However, the above-mentioned pressure-sensitive adhesive sheets have problems of contaminants. Depending on the kind of the laminate film, lamination of films having different elastic moduli in order to decrease residual stress may be components of the film to bleed out and so that to migrate through the pressure-sensitive adhesive layer to the surface thereof, thus contaminating the surface of the adherend. Also, there occurs contamination of the surface of the adherend due to organic substances or particles from the pressure-sensitive adhesive.

After the dicing step in which a wafer is cut into chips, the wafer is wire-bonded, sealed with a resin and so on. Pressure-sensitive adhesive sheets used in these steps must not contaminate adherend such as a wafer by organic substances or particles derived from the pressure-sensitive adhesive that constitute the pressure-sensitive adhesive layer.

The contaminants on the surface of wafers are known to give adverse influence to the shear strength of the wire-bonding. That is, in the wire-bonding performed when a semiconductor chip is produced, the bonding strength between a ball and a pad is required to be high. Organic substances or particles attached to the surface of aluminum surface on the wafer are a factor that prevents bonding of gold wire onto the surface of aluminum. Further, when a large amount of contaminant is present on the surface of aluminum, the contaminant serves as a starting point from which voids grow, thus causing peeling-off of the sealant resin or cracks in the sealant resin, so that the shear strength of the wire-bonding is decreased.

On the other hand, pressure-sensitive adhesives that have been conventionally used include solvent-type acrylic pressure-sensitive adhesives. Since the solvent-type acrylic pressure-sensitive adhesives are synthesized in organic solvents, evaporation of the solvent upon their coating causes environmental pollution, so that conversion of them into aqueous dispersion-type acrylic pressure-sensitive adhesives is being contemplated. However, since the aqueous dispersion-type acrylic pressure-sensitive adhesives contain an emulsifier in contrast to the solvent-type acrylic pressure-sensitive adhesives, so that they can not achieve bonding with low contamination.

In particular, with increasing requirements for higher density and higher performance of integrated semiconductor circuits in recent years, control of contamination on the circuit surface of semiconductor wafers and semiconductor chips obtained therefrom is becoming severer. Accordingly, a further improvement in low contamination property of the pressure-sensitive adhesive sheets used of processing of wafers is demanded.

The present invention has been made to solve the above-mentioned problems. Accordingly, it is an object of the present invention to provide a pressure-sensitive adhesive sheet that can be used in the step of processing an article such as a semiconductor wafer that does not cause breakage of a semiconductor wafer during grinding of the wafer even when the wafer is thin, that causes a wafer to show a less curl due to the residual stress of the pressure-sensitive adhesive sheet, that also has excellent anchoring power with the pressure-sensitive adhesive layer, and that can achieve low contamination. It is another object of the present invention to provide a method of processing an article by using such a pressure-sensitive adhesive sheet.

## SUMMARY OF THE INVENTION

The present invention provides a pressure-sensitive adhesive sheet that has a base, an intermediate layer and a pressure-sensitive adhesive layer in order, wherein the intermediate layer has an elastic modulus in tension at 23°C of 1 MPa or more and 100 MPa or less, the intermediate layer includes an acrylic-based polymer formed by polymerization of a (meth)acrylic-based monomer mixture containing 1% by weight or more and 20% by weight or less of a nitrogen-containing acrylic monomer, wherein the acrylic-based polymer contains 20% by weight or less of a polymer component having a molecular weight of 100,000 or less, and wherein the base includes at least one film having an elastic modulus in tension at 23°C of 0.6 GPa or more.

Here, the thickness of the intermediate layer may be 50 $\mu$m or more.

In the present invention, it is preferable that the intermediate layer is formed by curing the above-mentioned monomer mixture by irradiation of radiation.

Further, preferably the pressure-sensitive adhesive sheet of the present invention is a pressure-sensitive adhesive sheet for processing a semiconductor wafer and it is preferable that it is used by being affixed to the semiconductor wafer and the resultant semiconductor wafer is high-precision processed in a held and/or protected state.

The present invention provides a method of processing an article, which comprises affixing any one of the pressure-sensitive adhesive sheets to the article to be high-precision-processed, and performing high-precision processing the article in a held and/or protected state.

Here, the article to be high-precision-processed may be a semiconductor wafer and the high-precision processing is back-grinding of the semiconductor wafer.

Further, in the present invention, it is preferable that assuming the semiconductor wafer has a diameter of "a (inch)" and a thickness after the grinding of "b ($\mu$m)", the semiconductor wafer is ground to a value b/a ($\mu$m/inch) of 27 ($\mu$m/inch) or less.

DETAILED DESCRIPTION

The pressure-sensitive adhesive sheet of the present invention is a laminate that has a base, an intermediate layer and a pressure-sensitive adhesive layer in order. The intermediate layer has an elastic modulus in tension at 23°C of 1 MPa or more and 100 MPa or less, preferably 3 MPa or more and 80 MPa or less. When the elastic modulus in tension of the intermediate layer is 1 MPa or more and 100 MPa or less, the workability of affixing a pressure-sensitive adhesive sheet on the surface of an article when processing the article can be improved and the workability of peeling the pressure-sensitive adhesive tape from the article after the processing can be improved.

In the present invention, the term "elastic modulus in tension" of the intermediate layer refers to an initial elastic modulus that is obtained from an S-S curve prepared by fabricating a target (here, an intermediate layer, a pressure-sensitive adhesive layer or the like) to be measured having a thickness of 10 $\mu$m or more and 100 $\mu$m or less and cutting it to strips having a width of 10 mm to make samples, drawing the strip-shaped sample (1-cm-long portion) at 23°C at a speed of 50 mm/minute, measuring elongation and plotting the results.

The intermediate layer includes an acrylic-based polymer obtained by polymerization of a (meth)acrylic-based monomer mixture. Here, the (meth) acrylic-based monomer mixture must contain from 1% by weight or more and 20% by weight or less, preferably 2% by weight or more and 15% by weight or less, and more preferably 2% by weight or more and 10% by weight or less of a nitrogen-containing acrylic monomer. When the amount of the nitrogen-containing acrylic monomer contained in the (meth) acrylic-based monomer mixture is less than 1% by weight, the adhesion with the pressure-sensitive adhesive layer becomes poor while when the amount of the nitrogen-containing acrylic monomer is more than 20% by weight, the components will bleed out from the intermediate layer and will migrate through the pressure-sensitive adhesive layer to the surface thereof, thus the surface of the adherend may be contaminated.

Note that when the (meth)acrylic-based monomer mixture is polymerized, it is preferable that a polymerization initiator is added and radiation is irradiated to form an intermediate layer. By copolymerizing the nitrogen-containing acrylic monomer, the adhesion between the intermediate layer and the pressure-sensitive adheseive layer, i.e., anchoring power can be increased due to the interaction between nitrogen and the polar component that is present in the pressure-sensitive adhesive.

The nitrogen-containing acrylic monomers contained in the (meth) acrylic-based monomer mixture include (meth)acrylamide, N,N-dimethyl(ineth)acrylamide, N,N-diethyl(meth)acrylamide, (meth)acryloylmorpholine, (meth)acetonitrile, vinylpyrrolidone, N-cyclohexyl maleimide, itaconimide, and N,N-dimethylaminoethyl(meth)acrylamide, and so on.

Examples of the acrylic-based monomer that constitutes the acrylic monomer mixture include (meth)acrylates such as methyl(meth)acrylate, ethyl (meth)acrylate, propyl (meth)acrylate,butyl(meth)acrylate,t-butyl(meth)acrylate, pentyl (meth)acrylate, hexyl (meth)acrylate, 2-ethylhexyl (meth)acrylate, octyl(meth)acrylate, isooctyl(meth)acrylate, nonyl (meth)acrylate, and isononyl (meth)acrylate, carboxyl group-containing monomers or acid anhydrides thereof, such as acrylic acid, methacrylic acid, itaconic acid, maleic acid, crotonic acid, and maleic anhydride.

When forming the intermediate layer of the present invention, it is preferable that the reaction mixture contains a photopolymerization initiator in addition to the acrylic-based monomer and the nitrogen-containing acrylic monomers. The photopolymerization initiators used in the present invention include $\alpha$-ketol-based compounds such as 4-(2-hydroxyethoxy)phenyl (2-hydroxy-2-propy) ketone, $\alpha$-hydroxy-$\alpha,\alpha$'- dimethylacetophenone, 2-methyl-2-hydroxypropiophenone, and 1-hydroxycyclohexyl phenyl ketone; acetophenone-based compounds such as methoxyacetophenone, 2,2-dimethoxy-2-phenylacetophenone, 2,2-diethoxyacetophenone, and 2-methyl-1-[4-(methylthio)phenyl]-2-morpholinopropane-1; benzoin ether-based compounds such as benzoin ethyl ether, benzoin isopropyl ether, and anisole in methyl ether; ketal-based compounds such as benzyl dimethyl ketal; aromatic sulfonyl chloride-based compounds such as 2-naphthalenesulfonyl chloride; optically active oxime-based compounds such as 1-phenyl-1,1-propanedione-2-(o-ethoxycarbonyl-oxime; benzophenone-based compounds such as benzophenone, benzoyl benzoate, and 3,3'-dimethyl-4-methoxybenzophenone; thioxanthone-based compounds such as thioxanthone, 2-chlorothioxanthone, 2-methylthioxanthone, 2,4-dimethylthioxanthone, isopropylthioxanthone, 2,4-dichlorothioxanthone, 2,4-diethyltioxanthone, and 2,4-diisopropylthioxanthone; camphor quinone; halogenated ketones; acyl phosphinoxides; acyl phosphonates and so on.

The blending amount of the photopolymerization initiator is preferably 0.01 parts by weight or more and 3 parts by weight or less, more preferably 0.1 part by weight or more and 1.5 parts by weight or less based on 100 parts by weight of a base polymer such as acrylic-based polymers that form the intermediate layer. When the blending amount of the photopolymerization initiator is more than 3 parts by weight, the amount of the low molecular weight component may become larger and contamination of a surface of the adherend may be increased by bleeding out of the low molecular weight component.

The intermediate layer may be subjected to crosslinking treatment with a polyfunctional monomer as necessary. Examples of the polyfunctional monomer used include ethylene glycol di(meth)acrylate, propylene glycol di(meth)acrylate, hexanediol di(meth)acrylate, neopentyl glycol di(meth)acrylate, trimethylolpropane tri(meth)acrylate, pentaerythritol tri(meth)acrylate, dipentaerythritol hexa(meth)acrylate, urethane acrylate, epoxy acrylate, and polyester acrylates.

These polyfunctional monomers maybe used singly or two or more of them may be used in combination.

The intermediate layer may contain commonly used additives, for example, ultraviolet absorbents, antioxidants, fillers, pigments, colorants, flame retardants, and antistatic agents as necessary as far as they do not deteriorate the effects of the present invention. The additives may be used in amounts that are usually used depending on their kind.

To adjust the viscosity upon coating, the intermediate layer may contain a small amount of a solvent. The solvent may be selected as appropriate from those solvents commonly used. Examples of such a solvent include toluene, ethyl acetate, butyl acetate, acetone, methyl ethyl ketone, methyl isobutyl ketone, cyclohexanone, and cyclopentanone.

In the present invention, the intermediate layer may be formed by coating the mixture containing a nitrogen-containing acrylic monomer, an acrylic-based monomer, and optionally a photopolymerization initiator on a base, and curing it by irradiating radiation, for example, ionizing radiation such as α-ray, β-ray, γ-ray, neutron beam, or electron beam, or radiation such as ultraviolet ray to form an intermediate layer. Also, the intermediate layer may be formed by coating the mixture on a base, superimposing a release-treated sheet (separator or the like over the coating on the base material, and irradiating radiation over through the separator to cure the coating.

In this case, to avoid inhibition of polymerization due to oxygen, the separator may be covered over the mixture containing nitrogen-containing acrylic monomer and acrylic-based monomer coated on the base material to shut out oxygen. Alternatively, the base may be placed in a vessel filled with an inert gas to decrease the concentration of oxygen in the atmosphere.

In the present invention, the kind of radiation and so on and the kind of the lamp to be used for irradiation may be selected as appropriate, and for irradiation of ultraviolet ray, a high-pressure mercury lamp, low-pressure lamps such as a fluorescent chemical lamp and a black light, ultraviolet source such as excimer laser and a metal halide lamp, and an electron beam source can be used.

The dose of ultraviolet or the like may be set up optionally depending on the characteristics required for the intermediate layer. Generally, the dose of ultraviolet ray is selected within the range of preferably 100 to 10,000 mJ/cm$^2$, and more preferably 100 to 5,000 mJ/cm$^2$. When the dose of ultraviolet ray is 100 mJ/cm$^2$ or more, a sufficient degree of polymerization can be obtained while a dose of ultraviolet ray being 10,000 mJ/cm$^2$ or less will cause no deterioration of the characteristics of the intermediate layer.

Further, the temperature at which ultraviolet ray is irradiated is not particularly limited and can be set up optionally. However, when the temperature is too high, termination reaction tends to occur due to the heat of polymerization and thus cause a reduction in the characteristics of the intermediate layer. Usually, the temperature is 70˚C or less, preferably 50˚C or less, and more preferably 30˚C or less.

The thus-obtained intermediate layer contains 20% by weight or less, preferably 18% by weight or less of the polymer component having a molecular weight of 100,000 or less. When the content of the polymer component having a molecular weight of 100,000 or less is more than 20% by weight, such a component bleeds out to cause contamination on the surface of the adherend. Note that the content of the component having a molecular weight of 100,000 or less can be obtained by preparing a differential molecular weight curve by using gel permeation chromatography, and obtaining area ratios along this curve.

The thickness of the intermediate layer in the pressure-sensitive adhesive sheet of the present invention may be selected as appropriate depending on the purpose and the like. In particular, when the pressure-sensitive adhesive sheet is used for processing a high-precision component, the thickness of the intermediate layer is preferably 50 μm or more, more preferably 80 μm or more in order to effectively prevent the curl of, for example, a wafer after grinding. The upper limit of the thickness of the intermediate layer is preferably 300 μm or less, more preferably 250 μm or less, and particularly preferably 200 μm or less to maintain the grinding accuracy.

The base that constitutes the pressure-sensitive adhesive sheet of the present invention has at least one layer that has an elastic modulus in tension at 23˚C of 0.6 GPa or more. This is because when the base has a high elastic modulus in tension and thus is hard, curling of wafers can be effectively prevented. The elastic modulus in tension of the base is preferably 1 GPa or more from the viewpoint of improvement of the workability in affixing and that of peeling-off of the pressure-sensitive adhesive sheet as well as prevention of curls after the grinding of wafers. Further, when the base material has too high an elastic modulus in tension, a trouble is caused when the pressure-sensitive adhesive sheet is peeled off from the wafer. Accordingly, the elastic modulus in tension of the base is preferably 10 GPa or less.

In the present invention, the term "elastic modulus in tension" of the base refers to an initial elastic modulus that is obtained from an S-S curve prepared by fabricating a target sucn as a base to be measured having a thickness of 10 μm or more and 100 μm or less and cutting it to strips having a width of 10 mm to make samples, drawing the strip-shaped sample (1-cm-long portion) at 23˚C at a speed of 100 %/minute, measuring elongation and plotting the results.

As the base in the present invention, various films that are employed in general pressure-sensitive adhesive sheets for processing semiconductor wafers can be used. Note that the term "film" as used herein refers also to sheet and the term "sheet" also refers to film.

The materials that constitute the base include, for example, polyolefins such as low density polyethylenes, linear polyethylenes, medium density polyethylenes, high density polyethylenes, ultra-low density polyethylenes, random copolymer polyethylenes, block copolymer polypropylenes, homopolypropylenes, polybutenes, and polymethylpentenes; polyesters such as ethylene/vinyl acetate copolymers, ionomer resins, ethylene/(meth)acrylic acid copolymers, ethylene/(meth)acrylate (random, alternate) copolymers, ethylene/butene copolymers, ethylene/hexene copolymers, polyurethanes, polyethylene terephthalates, polybutylene terephthalates, and polyethylene naphthalates; polycarbonates; polyamides; polyimides; polystyrenes; polyether ether ketones, polyvinyl chlorides; polyvinylidene chlorides; fluororesins; cellulose-based resins; and crosslinked polymers thereof. These materials may be used singly or a blend of a plurality of kinds of the materials may be used.

It is preferable that the material of film that constitutes the base is determined as appropriate depending on the purpose, kind of the pressure-sensitive adhesive layers to be provided and so on. For example, when an ultraviolet-curing type pressure-sensitive adhesive is provided, a base having a high ultraviolet permeability is preferable. The base composed of such a material may be undrawn or monoaxially or biaxially drawn as necessary.

However, the base used in the present invention must contain at least one layer having an elastic modulus in tension at 23˚C of 0.6 GPa or more. Examples of such a film include polyester films such as polyethylene terephthalate films, polybutylene terephthalate films, and polyethylene naphthalate films; polyolefin-based films such as biaxially drawn polypropylene films, and high density polyethylene films; polycarbonate films; drawn polyamide films; polyether ether ketone films; styrene-based polymer films such as polystyrene films; and so on.

The base may be either of a single layer construction or of a multi-layer construction. When the base is of a multi-layer construction, it can be constituted by combining, for example, a film formed from the acrylic-based polymer or a film formed from a mixture of an acrylic monomer and urethane may be combined with the above-mentioned layer having an elastic modulus in tension at 23˚C of 0.6 GPa or more.

The base may contain generally used additives as necessary as far as the effects of the present invention are not deteriorated. Examples of such additives include antioxidants, fillers, pigments, colorants, flame retardants, antistatic agents, and ultraviolet absorbents.

Further, in the present invention, conventional physical treatment or chemical treatment such as matte treatment, corona discharge treatment, primer treatment, crosslinking treatment (chemical crosslinking treatment with, for example, silane) may be performed to a surface of the base as necessary.

While it is preferable that the base used in the present invention has a greater thickness (total thickness in the case of a laminate) in order to increase the rigidity of wafers, the thickness of the base is preferably about 10 μm or more and about 200 μm or less, more preferably about 50 μm or more and about 100 μm or less, taking into consideration a space in casset case to store wafers during processing, and workability peeling when the pressure-sensitive adhesive sheet is peeled off after the processing of wafers or other articles.

The pressure-sensitive adhesive sheet of the present invention has a pressure-sensitive adhesive layer on the intermediate layer.

Preferably, the pressure-sensitive adhesive layer that constitutes the pressure-sensitive adhesive sheet of the present invention has an elastic modulus in tension of 0.1 GPa or less. The elastic modulus in tension of the pressure-sensitive adhesive layer can be adjusted by selecting the kind and composition of the base resins of the pressure-sensitive adhesive that constitute the pressure-sensitive adhesive layer, the kind of crosslinking agent and so on, and blending ratios thereof as appropriate. For example, the elastic modulus in tension of the pressure-sensitive adhesive layer can be adjusted by controlling the glass transition temperature (Tg) and crosslink density of the base polymer.

As the pressure-sensitive adhesive that constitutes the pressure-sensitive adhesive layer, for example, generally used pressure-sensitive adhesive can be used. More particularly, acrylic-based pressure-sensitive adhesives, rubber-based pressure-sensitive adhesives that contain rubber polymers such as natural rubber and styrene-based copolymers as base polymer can be used. It is preferable to use acrylic-based pressure-sensitive adhesives as a base polymer from among them from the viewpoints of adhesion to semiconductor wafers and the ability to clean and wash the semiconductor wafers with super-pure water or organic solvents such as alcohols, after the peeling off the pressure-sensitive adhesive sheet.

Examples of the acrylic-based polymer include those acrylic-based polymers obtained by polymerizing a monomer component consisting of one or more monomers selected from the group consisting of alkyl (meth)acrylates (for example, linear or branched alkyl esters having 1 to 30 carbon atoms of alkyl group, preferably 4 to 18 carbon atoms such as methyl esters, ethyl esters, propyl esters, isopropyl esters, butyl esters, isobutyl esters, s-butyl esters, t-butyl esters, pentyl esters, isopentyl esters, hexyl esters, heptyl esters, octyl esters, 2-ethylhexyl esters, isooctyl esters, nonyl esters, decyl esters, isodecyl esters, undecyl esters, dodecyl esters, tridecyl esters, tetradecyl esters, hexadeoyl esters, octadecyl esters, and eicosyl esters) and cycloalkyl (meth)acrylates (for example, cyclopentyl esters, cyclohexyl esters and so on) as monomer components.

Note that the term "(meth)acrylates" refers to acrylates and/or methacrylates (i.e., acrylates, methacrylates, or both acrylates and methacrylates). The term " (meth) as used herein for all the occurrences shall be understood similarly.

The acrylic-based polymers may contain units corresponding to other monomer components that are copolymerizable with the alkyl (meth)aorylates or cycloalkyl (meth)acrylates in order to modify cohesive force, heat resistance and so on.

Examples of such a monomer component include carboxylic group-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride and itaconic anhydride; hydroxyl group-containing monomers such as 2-hydroxylethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate; sulfonic group-containing monomers such as styrenesulfonic acid, allyl sulfonate, 2-(meth)acrylamide-2-methylpropanesulfonate, (meth)acrylamidepropanesulfonate, sulfopropyl (meth)acrylate, and (meth)acryloyloxynaphthalenesulfonate; phosphate group-containing monomers such as 2-hydroxyethylacryloyl phosphate; acrylamide, and acrylonitrile and so on.

These copolymerizable monomer components can be used singly or two or more of them can be used in combination. The amount of the copolymerizable monomers is preferably 40% by weight or less.

Further, the acrylic-based polymer may contain a polyfunctional monomer for crosslinking. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy(meth)acrylate, polyester (meth)acrylate, and urethane (meth)acrylate.

Also, these polyfunctional monomers can be used singly or two or more of them can be used in combination. The amount of the polyfunctional monomer to be used is preferably 30% by weight or less based on the total monomer components from the viewpoint of adhesive properties.

The acrylic-based polymer can be obtained by polymerizing a mixture containing only one species of monomer or a mixture containing two or more species of monomer. The polymerization method for forming the acrylic-based polymer may be any of a solution polymerization method, an emulsion polymerization method, a mass polymerization method, a suspension polymerization method and so on.

The pressure-sensitive adhesive layer preferably contains a smaller amount of low molecular weight substances in order not to contaminate the affixing surface of the articles such as semiconductor wafers. From this viewpoint, the acrylic-based polymer has a number average molecular weight on the order of, preferably 300 , 000 or more, and more preferably 400,000 to 3,000,000.

Further, to increase the number-average molecular weight of the acrylic-based polymer, an external crosslinking method can be adopted as appropriate. As such an external crosslinking method is exemplified a method in which the reaction is performed with adding a crosslinking agent such as a polyisocyanate compound, an epoxy compound, an aziridine compound, or a melamine-based crosslinking agent. The amount of the crosslinking agent to be used is determined depending on the balance with the base polymer to be polymerized and further on the purpose for which the pressure-sensitive adhesive is used. Generally, it is preferable that about 1 to about 5 parts by weight of the crosslinking agent is blended to 100 parts by weight of the base polymer. Further, the pressure-sensitive adhesive may contain various conventionally known additives such as tackifiers and antioxidants.

In the present invention, the pressure-sensitive adhesive that is used is preferably a radiation-curing type pressure-sensitive adhesive. For example, the radiation curing type pressure-sensitive adhesive can be obtained by blending a tacky substance with an oligomer component that cures when irradiated with radiation and so on to form a low-adherent substance. A pressure-sensitive adhesive sheet with its pressure-sensitive adhesive layer being formed with the radiation curing type pressure-sensitive adhesive can be readily affixed to an article with ease since the pressure-sensitive adhesive is imparted plastic flowability by the oligomer component while it can be readily released from the article such as a semiconductor wafer upon peeling the sheet therefrom after the back-grinding step by irradiation of radiation to form a low-adherent substance.

The radiation curing type pressue-sensitive adhesive that can be used has a radiation curing functional group such as a carbon-carbon double bond in the molecule thereof and exhibits tackiness. For example, use can be made of an additive type radiation curing type pressure-sensitive adhesive that is obtained by blending a conventional pressure-sensitive adhesive with a radiation curing monomer or oligomer component, an intrinsic type radiation curing type pressure-sensitive adhesive that contains a base polymer having a carbon-carbon double bond in the main chain or at the terminal or terminals of the main chain, and so on. Radiations that can be used to cure the pressure-sensitive adhesive layer include, for example, X-ray, electron beam, and ultraviolet ray and so on. It is preferable that ultraviolet ray is used in view of ease of handling. However, the present invention is not limited thereto.

As the general pressure-sensitive adhesive that constitutes the additive type radiation curing type pressure-sensitive adhesive, pressure-sensitive adhesives such as the above-mentioned acrylic-based pressure-sensitive adhesives and rubber-based pressure-sensitive adhesives can be used.

Examples of the monomer having a radiation curing functional group include urethane oligomers, urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, and 1,4-butanediol di(meth)acrylate and so on. On the other hand, radiation curing oligomer components include various oligomers such as urethane-based oligomers, polyether-based oligomers, polyester-based oligomers, polycarbonate-based oligomers, polybutadiene-based oligomers and so on. Those oligomers that have a molecular weight in the range of about 100 to about 30 , 000 are suitable. The blending amount of the monomer component or oligomer component having a radiation curing functional group is, for example, preferably about 5 to about 500 parts by weight, more preferably about 40 to about 150 parts by weight based on 100 parts by weight of the base polymer such as the acrylic-based polymer that constitutes the pressure-sensitive adhesive.

The intrinsic type radiation curing type pressure-sensitive adhesives do not have to contain the oligomer component or the like that is a low polymerizing component and does not contain it much. Accordingly, there does not occur the situation in which the oligomer component or the like migrates in the pressure-sensitive adhesive with time, so that a pressure-sensitive adhesive layer having a stable layer construction can be formed.

In the intrinsic type radiation curing type pressure-sensitive adhesive, polymers that have a carbon-carbon double bond and have tackiness can be used as the base polymers without limitations. Such base polymers preferably are acrylic-based polymers in their basic skeleton. The acrylic-based polymers that are used here can be the same as those acrylic-based polymers already exemplified in the explanation of the acrylic-based pressure-sensitive adhesives.

The method of introducing a carbon-carbon double bond into an acrylic-based polymer as a basic skeleton is not particularly limited and various methods may be adopted. In the present invention, it is preferable that the carbon-carbon double bond is introduced into side chain of the acrylic-based polymer to form a base polymer having a carbon-carbon double bond. Specifically, the carbon-carbon double bond can be introduced into sidechain of the acrylic-based polymer, for example, by preliminarily copolymerizing an acrylic-based polymer with a monomer having a first functional group, and then reacting the resultant polymer with a compound having a carbon-carbon double bond and a second functional group that can react with the first functional group by a condensation or addition reaction such that the radiation curing of the carbon-carbon double bond is maintained.

Examples of combination of the functional group of a monomer to be copolymerized with the acrylic-based polymer and a functional group that can react with the functional group of the monomer are presented below. Such combinations include, for example, a carboxyl group and an epoxy group, a carboxyl group and an aziridyl group, a hydroxyl group and an isocyanate group, and so on. Among the combinations of functional groups, the combination of a hydroxyl group and an isocyanate group is preferable in view of ease of tracing the reaction.

Further, in the presented combinations, any of the functional groups in the combination may be present on the acrylic-based polymer as the basic skeleton. For example, in the combination of a hydroxyl group and an isocyanate group, it is preferable that the acrylic-based polymer has a hydroxyl group and the compound having a functional group that can react with the functional group of the monomer to be preliminarily copolymerized with the acrylic polymer has an isocyanete group.

In this case, examples of the compound having an isocyanate group include methacryloyl isocyanate,2-methacryloyloxyethyl isocyanate, and m-isopropenyl-$\alpha$,$\alpha$-dimethylbenzyl isocyanate.

Examples of the acrylic-based polymer having a functional group (here, a hydroxyl group) include those acrylic-based polymers that are copolymerized with one or more compounds selected from the group comprising the above-mentioned hydroxyl group-containing monomers that have been exemplified in the description with respect to the acrylic-based pressure-sensitive adhesives and in addition 2-hydroxyethyl vinyl ether-based compounds, 4-hydroxybutyl vinyl-based ether compounds, and diethylene glycol monovinyl ether-based compounds.

The intrinsic type radiation curing type pressure-sensitive adhesive may be comprised singly by a base polymer having a carbon-carbon double bond (in particular acrylic-based polymer) but as far as its characteristics are not deteriorated, it may be blended with the above-mentioned radiation curing monomer component or oligomer component. The blending amount of the radiation curing monomer or oligomer component is in the range of usually 30 parts by weight or less, preferably 0 to 10 parts by weight based on 100 parts by weight of the base polymer.

The radiation curing type pressure-sensitive adhesives may contain a photopolymerization initiator when they are cured with radiation such as ultraviolet ray. Examples of the photopolymerization initiator include $\alpha$-ketal-based compounds such as 4-(2-hydroxyethoxy)phenyl(2-hydroxy-2-propyl)ketone, $\alpha$-hydroxy-$\alpha$,$\alpha$'-dimethylacetophenone, 2-methyl-2-hydroxypropiophenone, and 1-hydroxycyclohexyl phenyl ketone; acetophenone-based compounds such as methoxyacetophenone,2,2-dimethoxy-2-phenylacetophenone,2,2-diethoxyacetophenone,and2-methyl-1-[4-(methylthlo)-phenyl]-2-morpholinopropane-1; benzoin ether-based compounds such as benzoin ethyl ether, benzoin isopropyl ether, and anisoin methyl ether; ketal-based compounds such as benzyl dimethyl ketal; aromatic sulfonyl chloride-based compounds such as 2-naphthalenesulfonyl chloride; optically active oxime-based compounds such as 1-phenone-1,1-propanedione-2-(o-ethoxycarbonyl)oxime; benzophenone-based compounds such as benzophenone, benzoyl benzoate, and 3,3'-dimethyl-4-methoxybenzophenone; thioxanthone-based compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone, halogenated ketones, acyl phosphinoxides, and acyl phosphonates.

The amount of the photopolymerization initiator to be blended is, for example, about 1 to about 10 parts by weight, preferably about 3 to about 5 parts by weight based on 100 parts by weight of the base polymer such as acrylic-based polymer that constitutes the pressure-sensitive adhesive.

In the present invention, the pressure-sensitive adhesive to be used may be a thermal foaming type pressure-sensitive adhesive. The thermal foaming type pressure-sensitive adhesive is a pressure-sensitive adhesive that includes the above-mentioned pressure-sensitive adhesive with which thermally expandable minute particles are blended. The thermal foaming type pressure-sensitive adhesive when heated have a reduced contact area due to foaming of the thermally expandable minute particles by heat, which facilitates peeling of the pressure-sensitive adhesive sheet from the article to which it is affixed. The thermally expandable minute particles have an average particle diameter of preferably about 1 $\mu$m to about 25 $\mu$m, more preferably about 5 $\mu$m to about 15 $\mu$m, particularly preferably about 10 $\mu$m.

The thermally expandable minute particles are not particularly limited as far as they can expand under heating. For example, it is preferable to use thermally expandable microcapsules that are obtained by encapsulating a gaseous foamable component having a low boiling point, such as butane, propane, or pentane, by an in-site polymerization method in a shell of a copolymer such as vinylidene chloride or acrylonitrile. Such thermally expandable microcapsules have an advantage that they have excellent dispersibility with the above-mentioned pressure-sensitive adhesive. As the thermally expandable microcapsules,for example,"Microsphere", trade name for a product manufactured by Matsumoto Yushi Seiyaku Co., Ltd. is commercially available.

Preferably, the blending amount of the thermally expandable microcapsules is selected such that the adhesive force of the pressure-sensitive adhesive layer can be reduced appropriately depending on the kind and so on of the pressure-sensitive adhesive and generally it is preferably about 1 part by weight to 100 parts by weight, more preferably 5 parts by weight to 50 parts by weight, and particularly preferably 10 parts by weight to 40 parts by weight based on 100 parts by weight of the base polymer.

In the present invention, the pressure-sensitive adhesive layer may be formed by coating the above-mentioned pressure-sensitive adhesive optionally using a solvent or the like directly on the intermediate layer. Alternatively, it may be formed by coating the pressure-sensitive adhesive on a release liner or the like to form a pressure-sensitive adhesive layer in advance and then applying the pressure-sensitive adhesive layer to the intermediate layer.

The thickness of the pressure-sensitive adhesive layer is not particularly limited and can be determined as appropriate. Taking into consideration other characteristics of the pressure-sensitive adhesive sheet, the thickness is preferably about 5 $\mu$m to about 100 $\mu$m, and more preferably 15 $\mu$m to 50 $\mu$m.

The pressure-sensitive adhesive sheet of the present invention may be provided with a separator as necessary for protecting the pressure-sensitive adhesive layer. The separators include, for example, paper, and a plastic film. The materials for forming the plastic film include polyethylene, polypropylene, polyethylene terephthalate and so on. Preferably, the surface of the separator is subjected to releasing surface treatment such as silicone treatment, long-chain alkyl treatment, or fluorine treatment as necessary in order to increase releasability from the pressure-sensitive adhesive layer. Usually, the thickness of the separator is preferably about 10 $\mu$m to about 200 $\mu$m, and more preferably about 25 $\mu$m to about 100 $\mu$m.

The pressure-sensitive adhesive sheet of the present invention is used by a conventional method that is used when articles, for example, semiconductor wafers are processed. Here, an example case is presented where the pressure-sensitive adhesive sheet is used upon grinding the backside of a semiconductor wafer. In this case, first a semiconductor wafer is mounted on a table such that a pattern surface, i.e., a surface on which a pattern such as IC circuitry is provided is up and the pressure-sensitive adhesive sheet of the present invention is superimposed on the pattern surface such that the pressure-sensitive adhesive layer side contacts the pattern surface. Then, the pressure-sensitive adhesive sheet is affixed by pressing it by press means such as a press roll. Alternatively, the semiconductor wafer and the pressure-sensitive adhesive sheet are placed in a compressible vessel (for example, an autoclave) as superimposed in the above-mentioned manner and then the inner pressure of the vessel is increased to have the semiconductor wafer and the pressure-sensitive adhesive sheet affixed to each other. A press means may be used in combination. Alternatively, the semiconductor wafer and the pressure-sensitive adhesive sheet can be affixed to each other in a vacuum chamber. Alternatively, the pressure-sensitive adhesive sheet can be affixed to the semiconductor wafer by heating the pressure-sensitive adhesive sheet to a temperature equal to or less than the melting point of the base of the pressure-sensitive adhesive sheet.

The method for polishing the backside of a semiconductor wafer is performed by a conventional polishing method. For example, a semiconductor wafer onto which a pressure-sensitive adhesive sheet is affixed in the above-mentioned manner is mounted on a polisher (back grinder) used as a processing machine for polishing and the backside of the wafer is polished to a desired thickness using a CMC (Chemical Mechanical Polishing) pad. When a pressure-sensitive adhesive sheet of which the pressure-sensitive adhesive layer is formed from the radiation curing-type pressure-sensitive adhesive is used, radiation is irradiated to the pressure-sensitive adhesive sheet after the polishing is finished to decrease the adhesive strength of the pressure-sensitive adhesive layer before the pressure-sensitive adhesive sheet can be peeled off from the wafer.

In the present invention, assuming the semiconductor wafer has a diameter of "a (inch)" and a thickness after the grinding of "b ($\mu$m)", back-grinding of the semiconductor wafer can be performed until a value b/a ($\mu$m/inch) of 27 ($\mu$m/inch) or less is reached. Therefore, according to the present invention, curl of the pressure-sensitive adhesive sheet can be curtailed even when the wafer is made thinner. The curl of a wafer becomes serious in the case of low profile grinding. However, by performing back-grinding using the pressure-sensitive adhesive sheet of the present invention, the value of b/a can be made 27 ($\mu$m/inch) orless, so that the curl of the wafer can be curtailed even when the wafer is made thinner. For example, in the case of an 8-inch-diameter wafer, the curl of the wafer can be curtailed even when the back-grinding is performed to a thickness of about 50 $\mu$m.

According to the present invention, a base material having a high elastic modulus in tension is affixed to a semiconductor wafer with an intermediate layer having a low elastic modulus in tension being sandwiched therebetween, so that the wafer as a whole has a suitable rigidity due to the interaction between the semiconductor wafer and the pressure-sensitive adhesive sheet, thus enabling the curl of the wafer after grinding to be effectively prevented. Further, because of having an intermediate layer having a low elastic modulus in tension, the pressure-sensitive adhesive sheet in itself is flexible, so that the affixing operation and peeling operation can be well performed. Here, it is significant to control the base and the intermediate layer to have respective specified elastic moduli in tension.

Since the pressure-sensitive adhesive sheet of the present invention has an intermediate layer that is formed from an acrylic-based monomer and a nitrogen-containing acrylic monomer, a pressure-sensitive adhesive sheet having sufficient anchoring power between the pressure-sensitive adhesive layer and the intermediate layer. Thus, low contamination can be achieved when the pressure-sensitive adhesive sheet is affixed to a surface of an article such as a wafer, for example, when grinding the article. Therefore, after processing the wafer, the amount of the organic component that remains on the surface of the wafer is small, resulting in achievement of low contamination without causing wire bonding failure or breakage of sealant resin.

Further, according to the present invention, a pressure-sensitive adhesive sheet can be formed without using solvents such as MEK, so that there arises no problem of environmental pollution.

EXAMPLES

Hereinafter, the present invention is explained by examples. However, the present invention is not limited thereto. In the following examples, all parts are parts by weight.

(Example 1)

In a reactor equipped with a condenser, a thermometer, and an agitator were charged 30 parts of butyl acrylate, 68 parts of t-butyl acrylate, and 2 parts of acryloylmorpholine (ACMO), and 0.3 parts of 2,2-dimethoxy-1,2-diphenylethan-1-one (registered trademark "IRGACURE 651," manufactured by Ciba Specialty Chemicals Co., Ltd.) as a photopolymerization initiator, and the mixture was irradiated with ultraviolet ray to effect photopolymerization to a degree of polymerization of 10% to increase the viscosity to prepare a prepolymer having a viscosity adjusted so that it could be coated.

Then, the resultant prepolymer was coated on a 75-$\mu$m-thick polyethylen terephthalate (PET) film to a thickness after curing of 100 $\mu$m. On this was superimposed a release-treated separator, and ultraviolet ray (illuminance 5 mW/cm$^2$, light amount 300 mJ/cm$^2$) by using a black light was irradiated to cure the coating to form an intermediate layer on the PET film. The PET film had an elastic modulus in tension at 23°C of 2 GPa.

Then, a blend of 97 parts of butyl acrylate, 3 parts of acrylic acid (AA), and 0.1 part of 2,2'-azobisisobutyronitrile (AIBN) was copolymerized in a toluene solution to obtain an acrylic-based copolymer having a weight-average molecular weight of $1.07 \times 10^6$ and a number-average molecular weight of $2.63 \times 10^5$. This was further mixed with 2 parts of a polyisocyanate crosslinking agent (trade name "CORONATE L," manufactured by Nippon Polyurethane Industry Co., Ltd.) and 2 parts of an epoxy crosslinking agent (trade name "TETRAD C," manufactured by Mitsubishi Gas Chemical Company, Inc.) based on 100 parts of solids of the acrylic-based copolymer solution to prepare a coating solution for a pressure-sensitive adhesive layer. The coating solution was coated on a release-treated separator to form a pressure-sensitive adhesive layer having a thickness of 30 $\mu$m. Then, the above-mentioned intermediate layer was superimposed and affixed onto the obtained pressure-sensitive adhesive layer to prepare a pressure-sensitive adhesive sheet having a layer construction of base material/intermediate layer/pressure-sensitive adhesive layer/separator. The pressure-sensitive adhesive layer had an elastic modulus in tension at 23°C of 0.1 MPa.

(Example 2)

A pressure-sensitive adhesive sheet was prepared in the same manner as that in Example 1 except that in the formation of the intermediate layer, a prepolymer was formed from 25 parts of butyl acrylate, 65 parts of t-butyl acrylate, 10 parts of acryloylmorpholine, and 0.3 parts of IRGACURE 651 as a photopolymerization initiator and the obtained polymer was coated on the base.

(Example 3)

A pressure-sensitive adhesive sheet was prepared in the same manner as that in Example 1 except that in the formation of the intermediate layer, a prepolymer was formed from 25 parts of butyl acrylate, 60 parts of t-butyl acrylate, 15 parts of acryloylmorpholine, and 0.3 parts of IRGACURE 651 as a photopolymerization initiator and the obtained polymer was coated on the base.

(Example 4)

A pressure-sensitive adhesive sheet was prepared in the same manner as that in Example 1 except that in the formation of the intermediate layer, a prepolymer was formed from 25 parts of butyl acrylate, 65 parts of t-butyl acrylate, 10 parts of N,N-dimethylacrylamide (DMAA), and 0.3 parts of IRGACURE 651 as a photopolymerization initiator and the obtained polymer was coated on the base.

(Comparative Example 1)

A pressure-sensitive adhesive sheet was prepared in the same manner as that in Example 1 except that the kinds and amounts of materials for forming the intermediate layer were changed to 60 parts of butyl acrylate, 40 parts of acryloylmorpholine, and 0.3 parts of IRGACURE 651 as a photopolymerization initiator.

(Comparative Example 2)

A pressure-sensitive adhesive sheet was prepared in the same manner as that in Example 1 except that the kinds and amounts of materials for forming the intermediate layer were changed to 30 parts of butyl acrylate, 70 parts of t-butyl acrylate, and 0.3 parts of IRGACURE 651 as a photopolymerization initiator.

(Comparative Example 3)

A pressure-sensitive adhesive sheet was prepared in the same manner as that in Example 1 except that the kinds and amounts of materials for forming the intermediate layer were changed to 30 parts of butyl acrylate, 70 parts of acryloylmorpholine, and 1.2 parts of IRGACURE 651 as a photopolymerization initiator.

(Comparative Example 4)

A pressure-sensitive adhesive sheet was prepared in the same manner as that in Example 1 except that the kinds and amounts of materials for forming the intermediate layer were changed to 25 parts of butyl acrylate, 65 parts of t-butyl acrylate, 10 parts of acryloylmorpholine, and 1.2 parts of IRGACURE 651 as a photopolymerization initiator.

(Comparative Example 5)

A pressure-sensitive adhesive sheet was prepared in the same manner as that in Example 1 except that the kinds and amounts of materials for forming the intermediate layer were changed to 25 parts of butyl acrylate, 65 parts of t-butyl acrylate, 10 parts of acryloylmorpholine, and 1.2 parts of IRGACURE 651 as a photopolymerization initiator, and the lamp for irradiating ultraviolet ray used in the formation of the intermediate layer was changed to a metal halide lamp (5 mW/cm$^2$, 5,000 mJ/cm$^2$).

(Comparative Example 6)

In a reactor equipped with a condenser, a thermometer, and an agitator were charged 10 parts of butyl acrylate, 25 parts of t-butyl acrylate, and 15 parts of acrylic acid (AA) as radical polymerizing monomers, 0.15 parts of 2,2-dimethoxy-1,2-diphenylethan-1-one (registered trademark "IRGACURE 651," manufactured by Ciba Specialty Chemicals Co., Ltd.) as a photopolymerization initiator, and 35 parts of polyoxytetramethylene glycol (molecular weight: 650, manufactured by Mitsubishi Chemical Corporation). While the mixture was being agitated, 15 parts of xylylene diisocyanate (XDI) was dripped and the resultant was allowed to react at 65˚C for 2 hours to obtain a mixture of a urethane polymer and the acrylic-based monomers. Note that the amounts of the polyisocyanate component and the polyol component were such that NCO/OH (equivalent ratio) = 1.10.

The mixture of the urethane polymer and the acrylic-based monomer was coated on a 75-μm-thick PET film to a thickness after curing of 100 μm. Over this, ultraviolet ray (illuminance 5 mW/cm$^2$, light amount 300 mJ/cm$^2$) was irradiated by using a black light to cure to form an intermediate layer on the PET film. The PET film had an elastic modulus in tension at 23°C of 2 GPa.

(Comparative Example 7)

A pressure-sensitive adhesive sheet was prepared in the same manner as that in Example 1 except that no intermediate layer was formed.

(Comparative Example 8)

A pressure-sensitive adhesive sheet was prepared in the same manner as that in Example 1 except that polybutylene terephthalate (PBT) was used as a resin for the intermediate layer and PBT was extruded on a PET film as a base and laminated (thickness of the intermediate layer: 100 μm; elastic modulus in tension: 1.1 GPa) to form a laminate.

<Evaluation Tests>

(1) Ratio (%) of polymers having a molecular weight of 100, 000 or less

The intermediate layer was measured by gel permeation chromatography under the following conditions. The results were calculated in terms of "TSK Standard Polystyrene" to obtain a differential molecular weight curve. From ratios of areas of the obtained differential molecular weight curve, the contents of the components having molecular weights of 100,000 or less in the intermediate layer were obtained.

GPC apparatus: HLC-8120GPC, manufactured by TOSOH.
Column: GMH-H(S)/GMH-H(S)
Flow rate: 0.5 ml/min
Detector: HLC-8120
Concentration: 0.1 wt%
Injection amount: 100 μl
Eluant: THF

(2) Elastic modulus in tension

Intermediate layers having the same compositions as those in Examples 1 to 4 and Comparative Examples 1 to 8 were each combined with separators to form a layer construction of separator/intermediate layer/separator. After these were cut to strips having a size of 1 cm in width × 1 cm in length and then the separators were removed from the strips to obtain samples consisting of only the intermediate layers. The samples were each drawn in the longitudinal direction at a drawing speed of 50 mm/min. Elongation of each sample was measured and the results were plotted to obtain an S-S curve, from which an initial elastic modulus at elongation, which was defined as an elastic modulus in tension of the sample. Various conditions required for the formation of the intermediate layers such as thickness and UV irradiation conditions adopted were the same as those used in the corresponding Examples and Comparative Examples.

(3) Evaluation of curl and cracks

Twenty (20) 8-inch wafers having a thickness of 625 μm were provided. On these wafers were affixed the obtained pressure-sensitive adhesive sheets using a protecting tape affixing machine "DR-8500III" manufactured by Nitto Seiki Co. , Ltd. Each of the wafers with the pressure-sensitive adhesive sheet affixed thereto was ground to a thickness of 50 μm by using a silicon wafer grinder manufactured by Disco Co., Ltd. and the resultant was evaluated as described below. Results obtained are shown in Table 1.

(i) Curls

Silicon wafers after the grinding with the pressure-sensitive sheet thereon were each left to stand on a flat plate so that the pressure-sensitive adhesive layer side up, and a distance between the most lifted up portion of the wafer (usually an edge of the wafer) and the surface of the flat plate was measured. The obtained distances were defined as curls. Then, an average of curls was calculated from measured values of 20 wafers. Silicon wafers having an average curl of 5 mm or less were judged to be fair.

(ii) Cracks

Silicon wafers were observed during their grinding whether or not cracks occurred therein. When even only one wafer showed occurrence of cracks, the evaluation of cracks was assigned a symbol "×" while when no cracks occurred in the wafer, the evaluation of cracks was assigned a symbol "○" based on judgment on five ground wafers.

(4)Evaluation of peelability

Using a mount peeler PM-8500 (manufactured by Nitto Denko Corporation),a pressure-sensitive adhesive sheet was peeled from a ground wafer that had been ground in the same manner as in the case of the evaluation of curl and cracks in (3) above. Peelability was evaluated based on the following standards.

Evaluation standards:

○: A case where the pressure-sensitive adhesive sheet could be peeled off without problems.
×: A case where peeling errors occurred that led to stop of the machine.

(5) Evaluation of contamination

The obtained pressure-sensitive adhesive sheets were each affixed to a silicon mirror wafer that was kept up clean by using a tape affixing machine "DR8500" manufactured by Nitto Seiki Co., Ltd. (affixing pressure: 2 MPa; affixing speed: 12 m/min). The resultant was left to stand in an atmosphere at 40˚C for 24 hours. Thereafter, the pressure-sensitive adhesive sheet was peeled by using a tape peeling machine "HR8500" manufactured by Nitto Seiki Co. , Ltd. (peeling speed: 12 m/min; peeling angle: 180˚). Organic substances, if any, transferred onto the wafer were measured by using an X-ray photoelectron spectrometer (XPS). Wafers having affixed thereon no pressure-sensitive adhesive sheet at all were also analyzed in the same manner as described above. Then, the amounts of the transferred organic substances were evaluated based on an increase in atomic % of the detected carbon atom. The atomic % of the carbon atom was calculated from respective elemental ratios (total 100%) of carbon, nitrogen, oxygen, silicon and so on. An increase in carbon ($\Delta$C) was compared with that in the state of the wafer before affixing thereon a pressure-sensitive adhesive sheet (blank) to obtain an index of contamination.

Note that the increase in carbon ($\Delta$C) was obtained according to the equation:

$$\Delta C = \text{(Amount of C on a surface of a wafer after peeling)} - \text{(Amount of C on the surface of a blank wafer before affixing)}.$$

Here, when $\Delta$C was 20% or less, contamination was judged to be low and the pressure-sensitive adhesive sheet was judged to be fair.

XPS apparatus: ESCA "Quantum 2000, " manufactured by Ulvac-Phi, Inc.

X-ray setting: Point analysis of 200-$\mu$m-diameter [30W (15 kV)]
X-ray source: Monochromatic Alk$\alpha$
Photoelectron takeoff angle: 45˚
Vacuum degree: $5 \times 10^{-9}$ torr
Neutralizing condition: Neutralization gun and ion gun in combination

For narrow scan spectra, the peak ascribable to the C-C bond of Cls was amended to 285.0 eV.

(6) Anchoring power

On the side of the pressure-sensitive adhesive layer of the obtained pressure-sensitive adhesive sheet was affixed a 50-$\mu$m-thick PET tape. Thereafter, T-peeling (a peeling method in which respective ends of a pressure-sensitive adhesive sheet and of a PET tape were drawn in opposite directions at 180° to cause peeling on the interface between the pressure-sensitive adhesive sheet and the intermediate layer so that the angle between the pressure-sensitive adhesive sheet and the intermediate layer was about 180°) and peeling power in that state was measured. Note that the anchoring power is preferably 3 N or more taking practical utility into consideration.

Table 1

| | Intermediate layer | | | | | Evaluation | | | | |
|---|---|---|---|---|---|---|---|---|---|---|
| | Material (Part) | | | Ratio of MW ≤ 100,000 | Elastic modulus in tension | Curl | Crack | Peelability | Contamination | Anchoring power |
| | | N-containing monomer | | (%) | (MPa) | (mm) | | | (%) | (N/20 mm) |
| Example 1 | Acrylic | ACMO | 2 | 12.5 | 7 | **4** | ○ | ○ | 11 | 5.8 |
| Example 2 | Acrylic | ACMO | 10 | 16.4 | 37 | **4** | ○ | ○ | 13 | 6.7 |
| Example 3 | Acrylic | ACMO | 15 | 14 | 55 | **4** | ○ | ○ | 15 | 6.5 |
| Example 4 | Acrylic | DMAA | 10 | 13.6 | 33 | **4** | ○ | ○ | 14 | 6.5 |
| C. Example 1 | Acrylic | ACMO | 40 | 14.2 | 10 | **4** | ○ | ○ | 23 | 7 |
| C. Example 2 | Acrylic | - | 0 | 9.3 | 6 | **4** | ○ | ○ | 10 | 2 |
| C. Example 3 | Acrylic | - | 0 | 30.2 | 4 | **4** | ○ | ○ | 11 | 2 |
| C. Example 4 | Acrylic | ACMO | 10 | 34 | 20 | **4** | ○ | ○ | 24 | 6 |
| C. Example 5 | Acrylic | ACMO | 10 | 46 | 25 | **4** | ○ | ○ | 24 | 6.3 |
| C. Example 6 | Acrylic Urethane | - | 0 | - | 2 | **4** | ○ | ○ | 25 | 3.2 |
| C. Example 7 | - | - | 0 | - | - | **6** | ○ | ○ | 11 | 7 |
| C. Example 8 | PBT | - | 0 | - | 1100 | **4** | × | × | 11 | 7 |

Table 1 indicates that the wafers processed using the pressure-sensitive adhesive sheets of Examples 1 to 4 of the present invention showed curls of 5 mm or less and caused no problem to occur during transportation to subsequent processing steps. Further, when wafers were processed by grinding them to a thickness of 50 μm by using the pressure-sensitive adhesive sheets of Examples 1 to 4, none of the wafers showed cracks and after the grinding, the pressure-sensitive adhesive sheets could be peeled from the wafers without problems. Furthermore, the pressure-sensitive adhesive sheets of Examples 1 to 4 showed good results in the evaluation of anchoring power, indicating that they caused no adhesive deposit on the adherend such as wafers, thus enabling to realize processing with low contamination. Since low contamination could be realized, there occurred neither wire bonding failure nor breakage of the sealant resin.

On the other hand, the pressure-sensitive adhesive sheets of Comparative Example 1, in which the content of the nitrogen-containing acrylic monomer was more than 20% by weight, Comparative Examples 4 and 5, in which the content of the polymer component having a molecular weight of 100,000 or less was more than 20% by weight, and Comparative Example 6, in which acrylic urethane was used in the formation of the intermediate layer had poor contamination preventing property, and the pressure-sensitive adhesive sheets of Comparative Examples 2 and 3, in which no nitrogen-containing acrylic monomer was used, had poor anchoring power. The pressure-sensitive adhesive sheet of Comparative Example 7, in which no intermediate layer was provided, showed a curl of 5 mm or more, and the pressure-sensitive adhesive sheet of Comparative Example 8 with an intermediate layer having an elastic modulus in tension of 1.1 GPa showed cracks upon grinding and peeling failure upon peeling.

According to the present invention, a pressure-sensitive adhesive sheet that can prevent the breakage of the article and cause no substantial curl, that can exhibit excellent anchorage with the pressure-sensitive adhesive layer, and that can achieve low contamination when articles such as semiconductor articles and optical articles are processed is provided, and a method of processing an article using such a pressure-sensitive adhesive sheet is provided. For example, when the pressure-sensitive adhesive sheet is affixed to a semiconductor wafer and the semiconductor wafer is polished to a thin film, the wafer is not damaged. In addition, since the curl of the wafer due to the residual stress in the pressure-sensitive adhesive sheet can be decreased, the finished wafers can be stored in a sole-use storage case.

[Industrial Applicability]

The pressure-sensitive adhesive sheets of the present invention can be advantageously used as a pressure-sensitive adhesive sheet used for processing semiconductor wafers when the backside of semiconductor wafers is ground or semiconductor wafers are diced. Further, it causes no interface fracture between the surface of aluminum and gold wire in wire bonding performed at the time of manufacturing semiconductor chips, thus enabling the wafer to maintain a high shear strength. Furthermore, taking the advantage of its characteristic of low contamination, the pressure-sensitive adhesive sheet can be used in avariety of applications in which the pressure-sensitive adhesive sheet is peeled during or after its use. For example, the pressure-sensitive adhesive sheet is widely used for protecting the surface of articles or for preventing breakage of the articles in the manufacture of high-precision processed parts, for example, various engineering materials, in particular semiconductors, circuits, various printed boards, various masks, and lead frames.

**Claims**

1.  A pressure-sensitive adhesive sheet comprising:

    a base material, an intermediate layer, and a pressure-sensitive adhesive layer in order;
    wherein the intermediate layer has an elastic modulus in tension at 23˚C of 1 MPa or more and 100 MPa or less, the intermediate layer includes an acrylic-based polymer formed by polymerization of a (meth)acrylic-based monomer mixture containing 1% by weight or more and 20% by weight or less of a nitrogen-containing acrylic monomer, and wherein the acrylic-based polymer contains 20% by weight or less of a polymer component having a molecular weight of 100,000 or less, and the base includes at least one film having an elastic modulus in tension at 23˚C of 0.6 GPa or more.

2.  The pressure-sensitive adhesive sheet as claimed in claim 1, wherein the thickness of the intermediate layer is 50 μm or more.

3.  The pressure-sensitive adhesive sheet as claimed in claim 1 , wherein the intermediate layer is formed by curing the mixture by irradiation of radiation.

4.  The pressure-sensitive adhesive sheet as claimed in claim 3, wherein the radiation is ultraviolet rays, and a dose of ultraviolet rays is 100 mJ/cm$^2$ or more, and 10,000 mJ/cm$^2$ or less.

5. The pressure-sensitive adhesive sheet as claimed in claim 1, wherein the pressure-sensitive adhesive sheet is affixed to a semiconductor wafer and for processing the semiconductor wafer in a held and/or protected state.

6. The pressure-sensitive adhesive sheet as claimed in claim 1, wherein the base has the thickness of 10 μm or more, and 200 μm or less.

7. The pressure-sensitive adhesive sheet as claimed in claim 1, wherein the pressure-sensitive adhesive layer has an elastic modulus in tension of 0.1 GPa or less.

8. The pressure-sensitive adhesive sheet as claimed in claim 2 , wherein the intermediate layer is formed by curing the mixture by irradiation of radiation.

9. The pressure-sensitive adhesive sheet as claimed in claim 8, wherein the radiation is ultraviolet rays, and a dose of ultraviolet rays is 100 mJ/cm$^2$ or more, and 10,000 mJ/cm$^2$ or less.

10. The pressure-sensitive adhesive sheet as claimed in claim 2, wherein the pressure-sensitive adhesive sheet is affixed to a semiconductor wafer and for processing the semiconductor wafer in a held and/or protected state.

11. The pressure-sensitive adhesive sheet as claimed in claim 2, wherein the base has the thickness of 10 μm or more, and 200 μm or less.

12. The pressure-sensitive adhesive sheet as claimed in claim 2 , wherein the pressure-sensitive adhesive layer has an elastic modulus in tension of 0.1 GPa or less.

13. A method of processing an article, comprising:

affixing a pressure-sensitive adhesive sheet to an article to be high-precision processed, and performing high-precision processing of the article in a held or protected state;
wherein the pressure-sensitive adhesive sheet having a base material an intermediate layer and a pressure-sensitive adhesive layer in order, wherein the intermediate layer has an elastic modulus at elongation at 23°C of 1 MPa or more and 100 MPa or less, the intermediate layer includes an acrylic polymer formed by polymerization of a (meth)acrylic monomer mixture containing 1% by weight or more and 20% by weight or less of a nitrogen-containing acrylic monomer based on 100 parts by weight of total monomers, and wherein the acrylic polymer contains 20% by weight or less of a polymer component having a molecular weight of 100,000 or less, and the base includes at least one film having an elastic modulus in tension at 23°C of 0.6 GPa or more.

14. The method of processing an article as claimed in claim 13, wherein the article to be high-precision processed is a semiconductor wafer and wherein the high-precision processing is back-grinding of the semiconductor wafer.

15. The method of processing an article as claimed in claim 13, wherein assuming the semiconductor wafer has a diameter of a (inch) and a thickness after the grinding of b (μm), the semiconductor wafer can be ground to a value b/a (μm/inch) of 27 (μm/inch) or less.

16. The method of processing an article as claimed in claim 13, wherein the intermediate layer has the thickness of 50 μm or more.

17. The method of processing an article as claimed in claim 13, wherein the intermediate layer is formed by curing the mixture by irradiation of radiation.

18. The method of processing an article as claimed in claim 13, wherein the base has the thickness of 10 μm or more, and 200 μm or less.

19. The method of processing an article as claimed in claim 13, wherein the pressure-sensitive adhesive layer has an elastic modulus in tension of 0.1 GPa or less.

**Patentansprüche**

1. Druckempfindliche Klebefolie, umfassend:

    ein Basismaterial, eine Zwischenschicht und eine druckempfindliche Klebeschicht in dieser Reihenfolge; wobei die Zwischenschicht einen Zugelastizitätsmodul bei 23˚C von 1 MPa oder mehr und 100 MPa oder weniger besitzt, die Zwischenschicht ein acrylbasiertes Polymer umfasst, gebildet durch Polymerisation einer (meth)acrylbasierten Monomermischung, enthaltend 1 Gew.-% oder mehr und 20 Gew.-% oder weniger eines stickstoffhaltigen Acrylmonomers, und wobei das acrylbasierte Polymer 20 Gew.-% oder weniger einer Polymerkomponente mit einem Molekulargewicht von 100.000 oder weniger enthält, und die Basis mindestens einen Film mit einem Zugelastizitätsmodul bei 23˚C von 0,6 GPa oder mehr umfasst.

2. Druckempfindliche Klebefolie gemäß Anspruch 1, wobei die Dicke der Zwischenschicht 50 $\mu$m oder mehr beträgt.

3. Druckempfindliche Klebefolie gemäß Anspruch 1, wobei die Zwischenschicht durch Härten der Mischung durch Bestrahlung mit Strahlen gebildet wird.

4. Druckempfindliche Klebefolie gemäß Anspruch 3, wobei die Strahlen Ultraviolettstrahlen sind und die Dosis der Ultraviolettstrahlen 100 mJ/cm$^2$ oder mehr und 10.000 mJ/cm$^2$ oder weniger beträgt.

5. Druckempfindliche Klebefolie gemäß Anspruch 1, wobei die druckempfindliche Klebefolie an einem Halbleiterwafer befestigt ist, (und) zum Verarbeiten des Halbleiterwafers in einem festgehaltenen und/oder geschützten Zustand.

6. Druckempfindliche Klebefolie gemäß Anspruch 1, wobei die Basis die Dicke von 10 $\mu$m oder mehr oder 200 $\mu$m oder weniger besitzt.

7. Druckempfindliche Klebefolie gemäß Anspruch 1, wobei die druckempfindliche Klebefolie einen Zugelastizitätsmodul von 0,1 GPa oder weniger besitzt.

8. Druckempfindliche Klebefolie gemäß Anspruch 2, wobei die Zwischenschicht gebildet wird durch Härten der Mischung durch Bestrahlung mit Strahlen.

9. Druckempfindliche Klebefolie gemäß Anspruch 8, wobei die Strahlen Ultraviolettstrahlen sind und die Dosis der Ultraviolettstrahlen 100 mJ/cm$^2$ oder mehr und 10.000 mJ/cm$^2$ oder weniger beträgt.

10. Druckempfindliche Klebefolie gemäß Anspruch 2, wobei die druckempfindliche Klebefolie auf einem Halbleiterwafer befestigt ist (und) zur Verarbeitung des Halbleiterwafers in einem festgehaltenen und/oder geschützten Zustand.

11. Druckempfindliche Klebefolie gemäß Anspruch 2, wobei die Basis die Dicke von 10 $\mu$m oder mehr und 200 $\mu$m oder weniger besitzt.

12. Druckempfindliche Klebefolie gemäß Anspruch 2, wobei die druckempfindliche Klebefolie einen Zugelastizitätsmodul von 0,1 GPa oder weniger besitzt.

13. Verfahren zum Verarbeiten eines Artikels, umfassend:

    Fixieren einer druckempfindlichen Klebefolie auf einem Artikel, der durch Hochpräzisionsverarbeitung verarbeitet werden soll und Durchführung von Hochpräzisionsverarbeitung des Artikels in einem festgehaltenen oder geschützten Zustand; wobei die druckempfindliche Klebefolie ein Basismaterial, eine Zwischenschicht und eine druckempfindliche Klebeschicht in dieser Reihenfolge besitzt, wobei die Zwischenschicht einen Dehnungselastizitätsmodul bei 23˚C von 1 MPa oder mehr und 100 MPa oder weniger aufweist, die Zwischenschicht ein Acrylpolymer umfasst, gebildet durch Polymerisation einer (Meth)acrylmonomermischung, enthaltend 1 Gew.-% oder mehr und 20 Ges.-% oder weniger eines stickstoffhaltigen Acrylmonomers, bezogen auf 100 Gewichtsteile der gesamten Monomere, und wobei das Acrylpolymer 20 Gew.-% oder weniger einer Polymerkomponente mit einem Molekulargewicht von 100.000 oder weniger enthält, und die Basis mindestens einen Film mit einem Zugelastizitätsmodul bei 23˚C von 0,6 GPa oder mehr umfasst.

**14.** Verfahren zum Verarbeiten eines Artikels gemäß Anspruch 13, wobei der durch Hochpräzisionsverarbeitung zu verarbeitende Artikel ein Halbleiterwafer ist und wobei die Hochpräzisionsverarbeitung das rückseitige Schleifen des Halbleiterwafers ist.

**15.** Verfahren zum Verarbeiten eines Artikels gemäß Anspruch 13, wobei unter der Annahme, dass der Halbleiterwafer einen Durchmesser von a (Inch) und eine Dicke nach dem Schleifen von b ($\mu$m) besitzt, der Halbleiterwafer auf einen Wert b/a (um/Inch) von 27 ($\mu$m/Inch) oder weniger geschliffen werden kann.

**16.** Verfahren zum Verarbeiten eines Artikels gemäß Anspruch 13, wobei die Zwischenschicht die Dicke von 50 $\mu$m oder mehr aufweist.

**17.** Verfahren zum Verarbeiten eines Artikels gemäß Anspruch 13, wobei die Zwischenschicht durch Härten der Mischung durch Bestrahlung mit Strahlen gebildet wird.

**18.** Verfahren zum Verarbeiten eines Artikels gemäß Anspruch 13, wobei die Basis die Dicke von 10 $\mu$m oder mehr und 100 $\mu$m oder weniger aufweist.

**19.** Verfahren zum Verarbeiten eines Artikels gemäß Anspruch 13, wobei die druckempfindliche Klebeschicht einen Zugelastizitätsmodul von 0,1 GPa oder weniger aufweist.

**Revendications**

**1.** Feuille adhésive sensible à la pression comprenant :

un matériau de base, une couche intermédiaire et une couche adhésive sensible à la pression, dans cet ordre ; dans laquelle la couche intermédiaire a un module d'élasticité en tension à 23 ˚C de 1 MPa ou plus et de 100 MPa ou moins, la couche intermédiaire comprenant un polymère à base d'acrylique formé par polymérisation d'un mélange monomère à base de (méth)acrylique contenant 1 % en poids ou plus et 20 % en poids ou moins d'un monomère acrylique contenant de l'azote, et dans laquelle le polymère à base d'acrylique contient 20 % en poids ou moins d'un composant polymère ayant une masse moléculaire de 100 000 ou moins et la base comprend au moins un film ayant un module d'élasticité en tension à 23 ˚C de 0,6 GPa ou plus.

**2.** Feuille adhésive sensible à la pression selon la revendication 1, dans laquelle l'épaisseur de la couche intermédiaire est de 50 $\mu$m ou plus.

**3.** Feuille adhésive sensible à la pression selon la revendication 1, dans laquelle la couche intermédiaire est fabriquée en faisant durcir le mélange par irradiation d'un rayonnement.

**4.** Feuille adhésive sensible à la pression selon la revendication 3, dans laquelle le rayonnement est constitué par des rayons ultraviolets, et une dose de rayons ultraviolets est de 100 mJ / cm$^2$ ou plus et de 10 000 mJ / cm$^2$ ou moins.

**5.** Feuille adhésive sensible à la pression selon la revendication 1, dans laquelle la feuille adhésive sensible à la pression est fixée à une tranche de semi-conducteur et destinée à permettre de traiter la tranche de semi-conducteur dans un état maintenu et/ou protégé.

**6.** Feuille adhésive sensible à la pression selon la revendication 1, dans laquelle la base a une épaisseur de 10 $\mu$m ou plus, et de 200 $\mu$m ou moins.

**7.** Feuille adhésive sensible à la pression selon la revendication 1, dans laquelle la feuille adhésive sensible à la pression a un module d'élasticité en tension de 0,1 GPa ou moins.

**8.** Feuille adhésive sensible à la pression selon la revendication 2, dans laquelle la couche intermédiaire est fabriquée en faisant durcir le mélange par irradiation d'un rayonnement.

**9.** Feuille adhésive sensible à la pression selon la revendication 8, dans laquelle le rayonnement est constitué par des rayons ultraviolets, et une dose de rayons ultraviolets est de 100 mJ / cm$^2$ ou plus et de 10 000 mJ / cm$^2$ ou moins.

**10.** Feuille adhésive sensible à la pression selon la revendication 2, dans laquelle la feuille adhésive sensible à la pression est fixée à une tranche de semi-conducteur et destinée à permettre de traiter la tranche de semi-conducteur dans un état maintenu et/ou protégé.

**11.** Feuille adhésive sensible à la pression selon la revendication 2, dans laquelle la base a une épaisseur de 10 $\mu$m ou plus, et de 200 $\mu$m ou moins.

**12.** Feuille adhésive sensible à la pression selon la revendication 2, dans laquelle la feuille adhésive sensible à la pression a un module d'élasticité en tension de 0,1 GPa ou moins.

**13.** Procédé de traitement d'un article, comprenant :

la fixation d'une feuille adhésive sensible à la pression à un article devant être soumis à un traitement de haute précision, et la mise en oeuvre du traitement de haute précision de l'article dans un état maintenu ou protégé ; dans lequel la feuille adhésive sensible à la pression comporte un matériau de base, une couche intermédiaire et une couche adhésive sensible à la pression, dans cet ordre, et dans lequel la couche intermédiaire a un module d'élasticité en élongation à 23˚C de 1 MPa ou plus et de 100 MPa ou moins, la couche intermédiaire comprenant un polymère à base d'acrylique formé par polymérisation d'un mélange monomère à base de (méth)acrylique contenant 1 % en poids ou plus et 20 % en poids ou moins d'un monomère acrylique contenant de l'azote sur la base de 100 parts en poids des monomères totaux, et dans lequel le polymère à base d'acrylique contient 20 % en poids ou moins d'un composant polymère ayant une masse moléculaire de 100 000 ou moins et la base comprend au moins un film ayant un module d'élasticité en tension à 23 ˚C de 0,6 GPa ou plus.

**14.** Procédé de traitement d'un article selon la revendication 13, dans lequel l'article devant être soumis à un traitement de haute précision est une tranche de semi-conducteur et dans lequel le traitement de haute précision est un meulage à l'arrière de la tranche de semi-conducteur.

**15.** Procédé de traitement d'un article selon la revendication 13, dans lequel, si on pose pour principe que la tranche de semi-conducteur présente un diamètre a (pouces) et une épaisseur après meulage b ($\mu$m), la tranche de semi-conducteur peut être meulée à une valeur de b / a ($\mu$m / pouce) de 27 ($\mu$m / pouce) ou moins.

**16.** Procédé de traitement d'un article selon la revendication 13, dans lequel la couche intermédiaire a une épaisseur de 50 $\mu$m ou plus.

**17.** Procédé de traitement d'un article selon la revendication 13, dans lequel la couche intermédiaire est fabriquée en faisant durcir le mélange par irradiation d'un rayonnement.

**18.** Procédé de traitement d'un article selon la revendication 13, dans lequel la base a une épaisseur de 10 $\mu$m ou plus, et de 200 $\mu$m ou moins.

**19.** Procédé de traitement d'un article selon la revendication 13, dans lequel la couche adhésive sensible à la pression a un module d'élasticité en tension de 0,1 GPa ou moins.

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000150432 A
- JP 2003261842 A
- JP 2004200451 A
- JP 2005019518 A
- JP 2002069396 A
- JP 2004107644 A
- JP 2004122758 A